# EUROPEAN PATENT SPECIFICATION

(11) **EP 3 584 442 B1**
(45) Date of publication and mention of the grant of the patent: **01.11.2023**
(21) Application number: 18754175.0
(22) Date of filing: 02.02.2018
(51) Int. Cl.: F04B 37/16, F04B 39/06, F04D 19/04

(54) **CONTROLLER AND VACUUM PUMP DEVICE**
STEUERGERÄT UND VAKUUMPUMPENVORRICHTUNG
CONTRÔLEUR ET DISPOSITIF DE POMPE À VIDE

(30) Priority: 17.02.2017 JP 2017027822
(43) Date of publication of application: 25.12.2019
(73) Proprietor: Edwards Japan Limited, Yachiyo-shi, Chiba 276-8523 (JP)
(72) Inventor: TATENO, Yasushi, Yachiyo-shi Chiba 276-8523 (JP)
(74) Representative: Openshaw & Co.
(86) International application number: PCT/JP2018/003628
(87) International publication number: WO 2018/150911

(56) References cited:
- EP-A2- 1 947 338
- WO-A1-2007/013274
- WO-A1-2016/132837
- CA-A- 490 167
- DE-T5-112013 006 329
- DE-U1- 20 309 856
- JP-A- H07 312 493
- JP-A- H07 312 493
- JP-A- 2003 060 135
- JP-A- 2004 197 687
- JP-A- 2004 251 133
- JP-A- 2004 281 079
- JP-A- 2004 281 079
- JP-A- 2006 278 735
- JP-A- 2013 021 750
- US-A1- 2015 098 838

## Description

The present invention relates to a controller and a vacuum pump device used in apparatuses such as a semiconductor manufacturing apparatus, an electron microscope, and a mass spectrometer.

In the various apparatuses described above, a vacuum pump device has been used to set the inside of a vacuum chamber to high vacuum. The vacuum pump device of this type includes a pump main body attached to a vacuum chamber and a controller that controls the operation of the pump main body.

In general, a turbo molecule pump has been known as the pump main body. In the turbo molecule pump, a rotor is rotatably supported in a pump case. Radial rotor blades arranged in a plurality of stages are provided on the outer wall surface of the rotor. On the other hand, stator blades arranged in a plurality of stages and each positioned between the rotor blades are disposed on the inner wall surface of the pump case facing the rotor blades. When the vacuum chamber is decompressed to a certain degree and then the rotor controlled by the controller is rotated at high speed, gas molecules colliding against the rotating rotor blades and the fixed stator blades are made to get a momentum and are exhausted. The gas molecules sucked into the pump main body from the vacuum chamber are exhausted while being compressed by this exhausting operation. A predetermined high vacuum degree is formed in the vacuum chamber.

In such a vacuum pump device, a control circuit board for mainly controlling a rotating motion of the rotor is incorporated in the inside of the controller. Elements configuring an electronic circuit are mounted on the control circuit board. Among the elements, there are elements that generate heat during operation such as a transistor and a resistor. The control circuit board is heated to very high temperature by the heat of the elements during the operation of the pump main body. When the operation of the pump main body is continued while leaving the control circuit board heated to high temperature by the heat generating elements, the life of the elements is markedly reduced because of the heat. Moreover, the heat leads to a failure of the controller, and the pump main body cannot be normally operated. Therefore, in the vacuum pump device, it is indispensable to remove the heat of the control circuit board installed in the controller.

As a method of removing the heat, examples that have been known include a method of setting a cooling fan on the inside of the controller and directly blow wind from the cooling fan against the circuit control board to forcibly cool the control circuit board and a method of exhausting high-temperature hot air in a housing to the outside to cool the control circuit board. However, these cooling systems including a cooling fan have the following problems. For example, when the vacuum pump device is attached to a vacuum chamber of a measuring device that requires a vibration proof environment such as an electron microscope, vibration of the pump main body has to be reduced as much as possible because the vibration may cause an adverse effect. Therefore, a magnetic bearing is adopted as a structure for supporting the rotating rotor, which is a cause of the vibration, to eliminate mechanical contact and achieve a reduction in the vibration of the pump main body. However, when the cooling fan is set on the inside of the controller as explained above, vibration of a motor that drives the cooling fan is transmitted to the pump main body via the controller, and the vibration of the pump main body propagates to the measuring device. Therefore, in the vacuum pump device that particularly requires a low vibration property, it is less desirable to adopt the forced air cooling system by the cooling fan that causes vibration.

On the other hand, Japanese Patent Application Publication No. H11-173293 discloses a method of cooling a controller without using a cooling fan. The method includes coupling a pump main body and a controller via a connection connector and setting a cooling jacket so as to come into close contact with the pump main body and the controller. Cooling water is then flown to a pipe in a cooling jacket to water-cool the controller via the cooling jacket. However, in the water cooling system using the cooling jacket, a separate piping facility for flowing the cooling water is necessary. The vacuum pump device increases in size and handling of the vacuum pump device is deteriorated. Moreover, the cooling water has to be continuously fed during the operation of the pump main body, which may lead to increase of running cost.

Japanese Patent No. 4796795 discloses a method of covering the periphery of a controller case with a heat sink and increasing heat dissipation of the controller case with natural air cooling without using a cooling fan and a cooling jacket. In the method, the heat sink is fixed to the outer surface of the controller by screws to conduct heat. The heat sink is formed in a plate shape that includes a plurality of fins arrayed on the outer wall surface, in order to radiate heat to the outside air. Such a plurality of fins are desirably attached to a plurality of surfaces or corners of the controller case from the viewpoint of the heat dissipation. However, when it is attempted to manufacture the controller case from a casting, a mold fitting the shapes of the fins on the surfaces and at the corners is necessary, a work process is complicated, and work manhour increases, leading to an increase in cost of the controller case. Therefore, when the cooling system in which the heat sink is fixed to the outer surface of the controller by the screws is adopted, work for fixing the heat sink is necessary. Therefore, work manhour increases and cost increases. Since the controller and the heat sink are separated, thermal conductivity is low, and the heat sink becomes large.

The document WO 2007 013274 discloses a controller which housing is provided with cooling fins. From the document JP 2013 021750 a housing for a mover of a linear motor is known which is cube shaped and which corners are provided with cooling fins.

The present invention has been made in view of such circumstances, and an object of the present invention is to solve some problems of conventional forced air cooling systems, the water cooling systems, and the natural air cooling systems and to provide a controller and a vacuum pump device that produce less vibration, have minimized sizes, are inexpensive and can efficiently remove heat of a control circuit installed in the controller.

The present invention has been proposed to achieve the object, and the invention according to claim 1 provides a controller including a control circuit that controls operation of a pump main body of a vacuum pump device, the controller including: a controller housing in which the control circuit is housed; and a heat sink formed integrally with the controller housing and including a plurality of fins formed so as to protrude outwardly from an outer peripheral surface of the controller housing.

With this configuration, although the control circuit housed in the controller housing is heated to high temperature by heat-generating elements such as transistors and resistors, heat is transferred to the fins of the heat sink formed integrally with the controller housing, naturally radiated into the atmosphere, and removed from the control circuit. Therefore, a sufficient air cooling effect can be obtained even if a cooling fan or the like, which is normally disposed in conventional forced air cooling systems and water cooling systems, is not installed on the inside of the controller. Since the heat sink is formed integrally with the control housing, a heat conduction effect is high and heat exchange efficiency with the outside air is improved.

An invention described in claim 2 provides a controller in which, in the configuration described in claim 1, the controller housing is made of a casting, and both side surfaces of ach of the fins are formed as tapered surfaces inclined toward a demolding direction.

With this configuration, it is possible to manufacture more easily, from the casting, the controller housing integrally including the heat sink. It is possible to manufacture the controller housing more easily from the casting by aligning the orientations of the tapered surfaces of the fins in the demolding direction of a mold.

An invention described in claim 3 provides, in the configuration described in claim 1 or 2, a controller in which each of the fins is formed in a substantially trapezoidal shape in a front view.

With this configuration, the fins are formed in the substantially trapezoidal shape in the front view. Therefore, when the fins are provided to be formed in a reverse trapezoidal shape with respect to an air passage formed between the fins, an opening area of an outlet portion of the air passage formed between the fins is smaller than an opening area of an inlet portion of the air passage. Therefore, heated air entering the air passage between the fins and flowing to an opening of the outlet portion is gradually compressed toward the opening of the outlet portion. After passing the opening of the outlet portion, the air is released from the compression and rapidly flows. Consequently, the air in the air passage is drawn by the rapid flow of the air, which passed the opening of the outlet portion, and flown to the opening side of the outlet portion. The flow of the air in the air passage is thereby made smooth and such smooth flow of air further improves the heat radiation effect.

An invention described in claim 4 provides a controller in which, in the configuration described in claim 1 or 2, each of the fins is formed in a substantially rhombic shape in a front view.

With this configuration, since a fin is formed in the substantially rhombic shape in the front view, in an air passage formed between the fins, an opening area of an intermediate portion of the air passage is smaller than an opening area of an inlet portion of the air passage. Therefore, heated air entering the air passage between the fins and flowing to an opening side of the outlet portion is gradually compressed toward an opening of the intermediate portion. After passing the opening of the intermediate portion, the air is released from the compression and rapidly flows. Consequently, the air in the air passage is drawn by the rapid flow of the air, which passed the opening of the intermediate portion, and further flown to the opening side of the outlet portion passing through the opening of the intermediate portion. The flow of the air in the air passage is thereby made smooth and such smooth flow of air further improves the heat radiation effect.

An invention described in claim 5 provides a controller in which, in the configuration described in claim 1 or 2, each of the fins is formed in a substantially polygonal shape including a triangular shape in a front view.

With this configuration, since a fin is formed in the substantially polygonal shape including the substantially triangular shape in the front view, in an air passage formed between the fins, an opening area of an outlet portion of the air passage is smaller than an opening area of an inlet portion of the air passage. Therefore, heated air entering the air passage between the fins and flowing to an opening side of the outlet portion is gradually compressed toward an opening of the outlet portion. After passing the opening of the outlet portion, the air is released from the compression and rapidly flows. Consequently, the air in the air passage is drawn by the rapid flow of the air, which passed the opening of the outlet portion, and flown to the opening side of the outlet portion. The flow of the air in the air passage is thereby made smooth and such smooth flow of air further improves the heat radiation effect.

An invention described in claim 6 provides a controller in which, in the configuration described in claim 2, the tapered surfaces of each of the fins are formed such that an opening area of an air passage formed between an adjacent pair of the fins becomes small on the pump main body side.

With this configuration, since the tapered surfaces of the fins are formed such that the opening area of the air passage formed between an adjacent pair of the fins becomes small on the pump main body side, an opening area of an outlet portion of the air passage formed between an adjacent pair of the fins is smaller than an opening area of an inlet portion of the air passage. Therefore, heated air entering the air passage between the fins and flowing to an opening side of the outlet portion is gradually compressed toward an opening of the outlet portion. After passing the opening of the outlet portion, the air is released from the compression and rapidly flows. Consequently, the air in the air passage is drawn by the rapid flow of the air, which passed the opening of the outlet portion, and flown to the opening side of the outlet portion. The flow of the air in the air passage is thereby made smooth and such smooth flow of air further improves the heat radiation effect.

An invention described in claim 7 provides a controller in which, in the configuration described in any one of claims 1 to 6, the controller housing is formed in a substantially polygonal shape in a front view, and the fins are formed at the corners or on the outer peripheral surface.

In general, an indicator is provided in a peripheral surface portion on a front surface side of the controller housing and a wire is provided in a peripheral surface portion on a rear side in the controller housing. Therefore, when the fins of the heat sink are disposed on the peripheral surface portions on the front side or the rear side, the fins sometimes obstruct the wire. In contrast, with the above configuration, by forming the controller in the substantially square shape in the plan view and providing the fins at the corners or on the outer peripheral surface, it is possible to form the fins without obstructing the wire and the like. If the corners are rounded, it is possible to secure a large space for forming the fins.

An invention described in claim 8 provides a controller in which, in the configuration described in claim 7, in the controller housing, tapered surfaces on both side surfaces of the fins are standardized such that a demolding direction of the fins formed at the corners or on the outer peripheral surface is same.

With this configuration, by aligning the orientations of the tapered surfaces of the fins in the heat sink in the drawing direction of a mold, a demolding direction of a casting becomes the same, and it is thus possible to reduce the number of molds for forming the fins.

An invention described in claim 9 provides a controller which, in the configuration described in claim 8, in the controller housing, the demolding direction of the fins is a direction along a center axis of the vacuum pump device.

With this configuration, since the demolding direction of the fins is the direction along the center axis of the vacuum pump device, it is possible to manufacture the controller housing using, for example, two molds in the direction along the center axis.

An invention described in claim 10 provides a vacuum pump device including the controller described in any one of claims 1 to 9.

With this configuration, it is possible to obtain a vacuum pump device that produces less vibration, has minimized sizes, is inexpensive, and can efficiently remove heat of a control circuit installed in the controller.

According to the present invention, heat generated in the control circuit housed in the controller housing is naturally radiated into the atmosphere through the fins of the heat sink formed integrally with the controller housing and is removed from the control circuit. Therefore, since a sufficient air cooling effect can be obtained even if a cooling fan or the like, which is normally disposed in conventional forced air cooling systems and water cooling systems, is not installed on the inside of the controller, vibration due to machine operation is eliminated, and it is possible to apply the present invention to a vacuum pump device required of a low vibration property. In the case of conventional forced air cooling systems and water cooling systems, a cooling fan and piping installation are separately necessary. However, the present invention enables to omit the cooling fan and the piping installation , to provide excellent handling workability, and to save running cost.

Further, in the case of a conventional heat sink system, the heat sink is formed separately from the controller housing and fixed by the screws. Therefore, work for fixing the heat sink is necessary for assembly and work manhour increases and cost increases. However, in the case of the present invention, since the heat sink is formed integrally with the control housing, assembly manhour can be reduced. Furthermore, in the case of the present invention, a heat conduction effect is high, heat exchange efficiency with the outside air is improved, and a reduction in the size of the controller can be achieved at the same time.
FIG. 1 is an exterior perspective view of a vacuum pump device including a controller according to a first embodiment of the present invention;
FIG. 2 is a front view of the vacuum pump device according to the first embodiment;
FIG. 3 is a plan view of the vacuum pump device according to the first embodiment;
FIG. 4 is a partially enlarged perspective view of a heat sink in the controller according to the first embodiment;
FIG. 5 is a front view illustrating a modification of the controller according to the first embodiment;
FIG. 6 is an exterior perspective view of a vacuum pump device including a controller according to a second embodiment of the present invention;
FIG. 7 is a partially enlarged perspective view of a heat sink in the controller according to the second embodiment; and
FIG. 8 is a plan view for explaining a modification of a heat sink portion in the controllers according to the first and second embodiments.

In order to achieve an object of providing a controller and a vacuum pump device that produce less vibration, has minimized sizes, are inexpensive, and can efficiently remove heat of a control circuit installed in the controller, the present invention provides a controller including a control circuit that controls the operation of a pump main body of the vacuum pump device. The controller including a controller housing in which the control circuit is housed, and a heat sink formed integrally with the controller housing and including a plurality of fins formed so as to protrude outwardly from the outer peripheral surface of the controller housing. With this configuration, the above object can be achieved.

Modes for carrying out the present invention are explained in detail below with reference to the attended drawings. In the following explanation, the same elements are denoted by the same reference numerals and signs throughout the entire explanation of embodiments. In the following explanation, expressions indicating directions such as an up-and-down direction and a left-and-right direction are not absolute and are appropriate when sections of a controller and a vacuum pump device of the present invention take postures drawn in the drawings. However, when the postures change, the expressions should be changed and interpreted according to the change of the postures. Embodiments

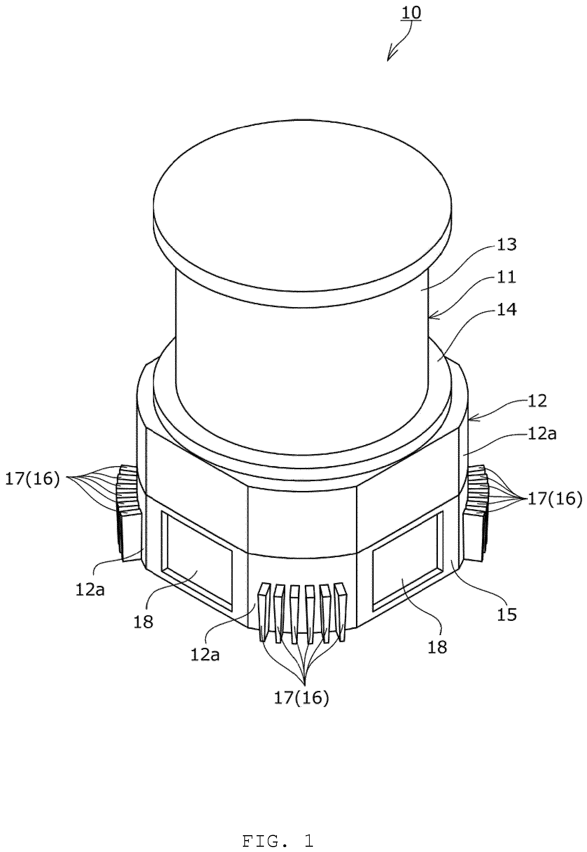

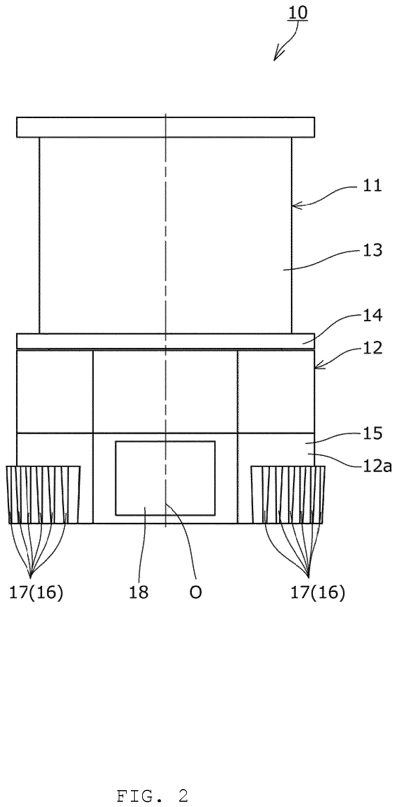

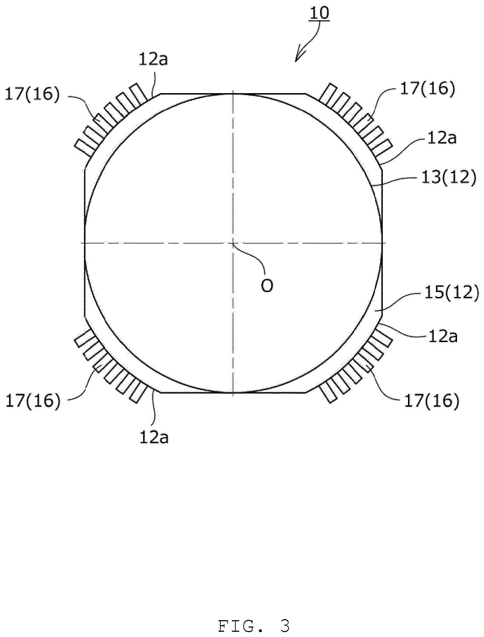

FIG. 1 is an exterior perspective view of a vacuum pump device 10 including a controller 12 according to a first embodiment of the present invention. FIG. 2 is a front view of the vacuum pump device 10. FIG. 3 is a plan view of the vacuum pump device 10.

The vacuum pump device 10 in the first embodiment can be applied to means for highly evacuating the inside of a vacuum chamber (not illustrated) of a target apparatus such as a semiconductor manufacturing apparatus, an electron microscope, or a mass spectrometer.

The vacuum pump device 10 illustrated in FIGS. 1 to 3 includes a pump main body 11 that sucks and exhausts gas molecules from the inside of a vacuum chamber and the controller 12 that controls the operation of the pump main body 11. The pump main body 11 is mounted on the upper surface of the controller 12. The pump main body 11 and the controller 12 are integrated.

The pump main body 11 is a turbo molecular pump, the outer side of which is covered with a cylindrical pump case 13 and which contains a rotor and a stator (not illustrated) therein. The bottom surface of the pump main body 11 is closed by a disk-shaped bottom lid 14. The controller 12 is covered with a controller housing 15. A control circuit board for mainly controlling a rotating motion of the rotor (not illustrated) is housed on the inside of the controller housing 15. Elements that generate heat during operation such as a transistor and a resistor are mounted on the control circuit board. The control circuit board and a control section in the pump main body 11 are electrically connected via a harness, a connector (both are not illustrated), and the like. Concerning internal structures of the pump main body 11 and the controller 12, for example, well-known means disclosed in Japanese Patent No. 4796795 can be used. Since the internal structures are unrelated to the gist of the present invention, detailed explanation of the internal structures is omitted.

The controller housing 15 is made of a casting such as aluminum diecast. As shown in FIG. 3, the controller housing 15 is formed in a substantially rectangular shape in a plan view. Four corners 12a of the controller housing 15 are each cut out to fit with a circumference (not shown in FIG. 3) drawn around a center axis O of the controller 12. The corners 12a are rounded. Further, heat sinks 16 are each provided at the corners 12a. Indicators 18 are provided in peripheral surface portions among the corners 12a on the front side of the controller housing 15. Although not illustrated in FIG. 3, an electric wire electrically connecting the pump main body 11 and the controller 12 is provided in a peripheral surface portion on the rear side of the controller housing 15.

The heat sinks 16 are radially outwardly formed from the outer peripheral surface of the controller housing 15 at the corners 12a of the controller housing 15. Each of the heat sinks 16 includes a plurality of (in this embodiment, six) fins 17 formed integrally with the controller housing 15.

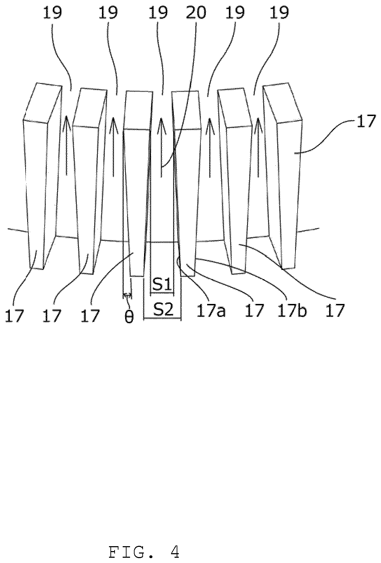

In the heat sink 16 in the first embodiment, from the viewpoint of further improving heat radiation performance and the viewpoint of facilitating demolding, as illustrated in FIGS. 2 and 4, the orientations of the fins 17 are aligned such that each of inclinations θ of both side surfaces (hereinafter referred to as "tapered surfaces") 17a and 17b is along a drawing direction of the mold. More specifically, the orientations of the fins 17 are aligned in a direction along the center axis O and in a form of an "inverted V" (like Japanese KATAKANA character " 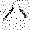 " (pronounced as "HA")) shape in which the tapered surfaces 17a and 17b of the fins 17 adjacent to each other spread out toward the end. The fins 17 are formed in a substantially inverted trapezoidal shape in a front view.

In this way, in the first embodiment, by aligning the orientations of the tapered surfaces 17a and 17b of the fins 17 in the heat sink 16 in the drawing direction of the mold, it is possible to facilitate manufacturing of the fins 17 with a casting and to save cost. That is, by aligning the orientations of the tapered surfaces 17a and 17b of the fins 17 in the heat sink 16 in the drawing direction of the mold, since the demolding direction of the casting becomes the same, it is possible to reduce the number of molds for forming the fins. For example, it is possible to manufacture the fins 17 with two molds in the demolding direction along the center axis O. When the fins 17 in the heat sink 16 are formed in a substantially inverted trapezoidal shape in a front view with respect to an air passage 19 formed between the fins 17 and are aligned in the "inverted V" shape in which the tapered surfaces 17a and 17b of the fins 17 adjacent to each other spread out toward the end, it is possible to further improve heat dissipation. An effect of improving heat dissipation is explained with reference to FIG. 4.

When the fins 17 are formed in the substantially inverted trapezoidal shape in the front view, in the air passage 19 having the "inverted V" shape formed by the tapered surfaces 17a and 17b of the fins 17 adjacent to each other, as illustrated in FIG. 4, an area S1 of an opening of an outlet portion of the air passage 19 (hereinafter simply referred to as "opening S1 of the outlet portion") is smaller than an area S2 of an opening of an inlet portion of the air passage 19 (hereinafter simply referred to as "opening S2 of the inlet portion"). Therefore, since the opening S1 of the outlet portion of the air passage 19 is smaller than the opening S2 of the inlet portion on the lower side, air entering the air passage 19 formed between the fins 17 and flowing to the opening S1 of the outlet portion (the flow is indicated by arrows 20 in FIG. 4) is gradually compressed toward the opening S1 of the outlet portion. When the air passes the opening S1 of the outlet portion, the air is released from the compression and rapidly flows. Consequently, the air in the air passage 19 is drawn by the rapid flow of the air, which passed the opening S1 of the outlet portion, and flown to the opening S1 side of the outlet portion. The flow of the air in the air passage 19 is made smooth and such smooth flow of air further improves the heat radiation effect.

The configuration of the vacuum pump device 10 according to the first embodiment is as explained above. In the vacuum pump device 10, when the controller 12 is turned on to actuate the pump main body 11, the control circuit board installed in the controller housing 15 is heated to high temperature by heat-generating elements such as transistors and resistor. However, heat of the control circuit board is transferred to the heat sinks 16 via the controller housing 15 and is further radiated by heat exchange via the fins 17 of the heat sinks 16, naturally air-cooled, and removed. In this case, since the opening S1 of the outlet portion of the air passage 19 is smaller than the opening S2 of the inlet portion of the air passage 19, the air passing through the air passage 19 smoothly flows. The heat radiation effect by the heat exchange can be further improved. The heat radiation effect of the controller 12 is greatly improved.

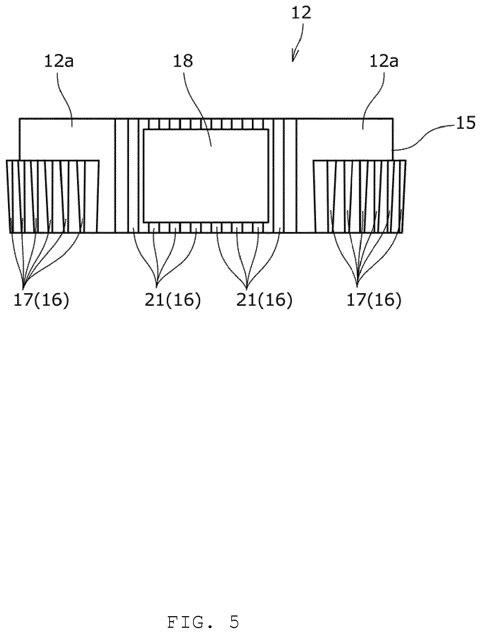

In the vacuum pump device 10 according to the first embodiment illustrated in FIGS. 1 to 4, the structure is disclosed in which the heat sinks 16 are formed at each of four corners 12a and are not formed in the peripheral surface portions where the indicators 18 are provided on the front side of the controller housing 15. However, as illustrated in FIG. 5, even on the peripheral surface portions where the indicators 18 are provided, fins 21 of the heat sinks 16 may be formed integrally with the controller housing 15 to surround the indicators 18. In the heat sinks 16 in this case, the fins 21 formed in a stripe shape are provided to extend in the up-and-down direction along the center axis O. However, the shape of the fins 21 is not limited to this.

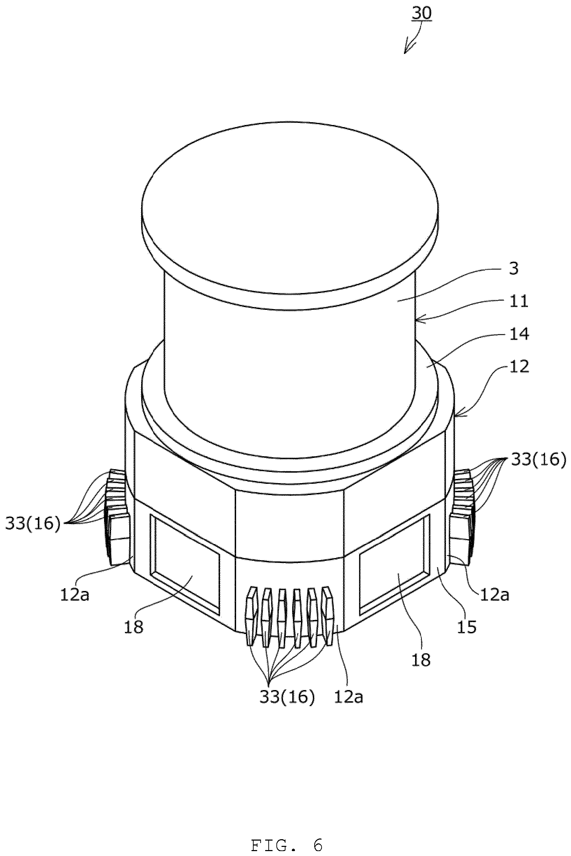

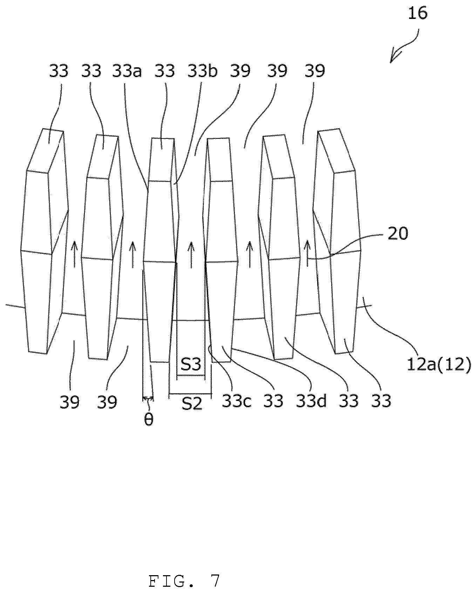

FIG. 6 is an exterior perspective view of a vacuum pump device 30 including the controller 12 according to a second embodiment of the present invention. FIG. 7 is a partially enlarged perspective view of the heat sink 16 in the controller 12. A configuration in the second embodiment is changed to a configuration in which the shape of fins 33 in the heat sinks 16 is formed in a substantially rhombic shape in a front view. The rest of the components are the same as the components illustrated in FIGS. 1 to 3. Thus, the same constituent portions are denoted by the same reference numerals and signs, and any redundant explanation of the constituent portions is omitted.

The heat sinks 16 of the controller 12 illustrated in FIG. 6 are radially outwardly formed from the outer peripheral surface of the controller housing 15 at the corners 12a of the controller housing 15. Each of the heat sinks 16 includes a plurality of (in this embodiment, six) fins 33 formed integrally with the controller housing 15.

In the heat sinks 16 in the second embodiment, as in the heat sinks 16 in the first embodiment, from the viewpoint of further improving heat radiation performance and the viewpoint of facilitating die cutting of a mold, as illustrated in FIGS. 6 and 7, the fins 33 are formed in a substantially rhombic shape in a front view. That is, the orientations of the fins 33 are aligned such that an inclination θ of both side surfaces (hereinafter referred to as "tapered surfaces") 33a and 33b is a drawing direction of the mold. That is, the orientations of the fins 33 are aligned in a direction along the center axis O and, in the upper half side of the rhombic, in a form of a substantial "V" shape in which the tapered surfaces 33a and 33b of the fins 33 adjacent to each other spread out upward and, in the lower half side of the rhombic, in a form of an "inverted V" shape in which the tapered surfaces 33c and 33d of the fins 33 adjacent to each other spread out to the end. The fins 33 are formed in a substantially rhombic shape in a front view.

In this way, in the second embodiment, as in the first embodiment, by aligning respective orientations of the tapered surfaces 33a and 33b, or 33c and 33d of the fins 33 in the heat sink 16 in the demolding direction of the mold, it is possible to facilitate manufacturing of the fins 33 with a casting and to save cost. When the heat sinks 16 are formed in the substantially rhombic shape in the front view and aligned in the form of the "inverted V" shape in which the tapered surfaces 33c and 33d of the fins 33 adjacent to each other spread out to the end, it is possible to further improve the heat dissipation. An effect of improving the heat dissipation is explained with reference to FIG. 7.

When the fins 33 are formed in the substantially rhombic shape in the front view, in an air passage 39 having an "inverted V" shape formed by tapered surfaces 33c and 33d of the fins 33 adjacent to each other, as illustrated in FIG. 7, an area S3 of an opening in an intermediate and outlet portion of the air passage 39 (hereinafter simply referred to as "opening S3 of the intermediate portion") is smaller than an area S2 of an opening of an inlet and outlet portion of the air passage 39 (hereinafter simply referred to as "opening S2 of the inlet and outlet portion"). Therefore, since the opening S3 of the intermediate and outlet portion of the air passage 39 is smaller than the opening S2 of the inlet portion on the lower side, air entering the air passage 39 formed between the fins 33 and flowing to the opening S2 of the intermediate portion is gradually compressed toward the opening S3 of the intermediate and outlet portion. After passing the opening S3 of the intermediate and outlet portion, since the upper side of the opening S3 spreads in the substantially V shape, the air is released from the compression and rapidly flows. Consequently, the air 20 in the air passage 39 is drawn by the rapid flow of the air, which passed through the opening S3 of the outlet portion, and fed to the opening S2 side of the outlet portion. The flow of the air in the air passage 39 is smoothed to further improve the heat radiation effect.

In the vacuum pump device 30 according to the second embodiment, as in the vacuum pump device 10 according to the first embodiment, when the controller 12 is turned on to actuate the pump main body 11, the control circuit board installed in the controller housing 15 is heated to high temperature by heat-generating elements such as transistors and resistors. However, heat of the control circuit board is transferred to the heat sinks 16 via the controller housing 15 and is further radiated by heat exchange via the fins 33 of the heat sinks 16, naturally air-cooled, and removed. In this case, since the opening S3 of the intermediate and outlet portion of the air passage 39 is smaller than the opening S2 of the inlet portion of the air passage 39, the air (a flow of the air is indicated by the arrows 20 in FIG. 7) passing through the air passage 39 is smoothly fed. The heat radiation effect by the heat exchange can be further improved. The heat radiation effect of the controller 12 is greatly improved.

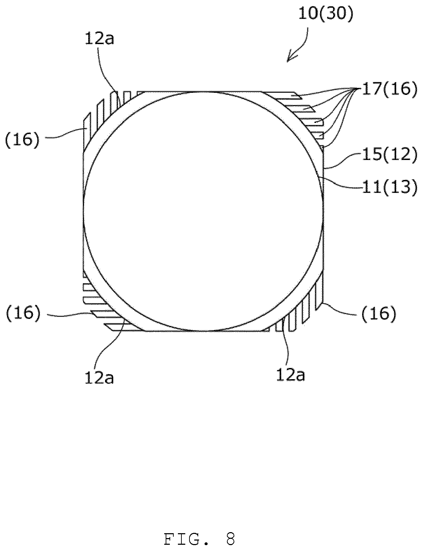

The above embodiments disclose structures in which the fins 17 of the heat sinks 16 in the first embodiment and the fins 33 of the heat sinks 16 in the second embodiment are provided radially outwardly from the center axis O of the controller 12. However, for example, as illustrated in FIG. 8, a structure in which the fins 17 are provided to be displaced in order by approximately 90 degrees for each of the corners 12a may be adopted.

The above embodiments also disclose structures in which the controller housing 15 in the first and second embodiments are formed in the substantially rectangular shape in the plan view. However, the shape of the controller housing 15 is not limited to the rectangular and may be formed in, for example, a triangular shape, a pentagonal shape, a hexagonal shape, or the like. The fins 17, 33, or the like of the heat sinks 16 may be provided to correspond to each corner.

- 10: Vacuum pump device
- 11: Pump main body
- 12: Controller
- 12a: Corner
- 13: Pump case
- 14: Bottom lid
- 15: Controller housing
- 16: Heat sink
- 17: Fin
- 17a, 17b: Tapered surface
- 18: Indicator
- 19: Air passage
- 20: Flow of air
- 21: Fin
- 30: Vacuum pump device
- 33: Fin
- 33a, 33b, 33c, 33d: Tapered surface
- 39: Air passage
- O: Center axis of the controller
- S1: Opening of an outlet portion
- S2: opening of an inlet portion
- S3: Opening of an intermediate portion

## Claims

1. A controller (12) including a control circuit that controls operation of a pump main body (11) of a vacuum pump device (10,30), the controller comprising:
a controller housing (15) in which the control circuit is housed; and
**characterized by** a plurality of heat sinks (16) formed integrally with the controller housing and including a plurality of fins (17, 21, 33) formed so as to protrude outwardly from an outer peripheral surface of the controller housing,
wherein the controller housing is formed in a rectangular shape in a plan view and has a plurality of corners (12a),
wherein the plurality of fins of the plurality of heat sinks are provided on each of the plurality of corners, and
at least one indicator (18) is provided in at least one of peripheral surface portions among the plurality of corners (12a) on the front side of the controller housing (15).

2. The controller according to claim 1, wherein
the controller housing is made of a casting, and both side surfaces of each of the fins are formed as tapered surfaces (17a, 17b, 33a, 33b, 33c, 33d) inclined toward a demolding direction.

3. The controller according to claim 1 or 2, wherein each of the fins is formed in a substantially trapezoidal shape in a front view.

4. The controller according to claim 1 or 2, wherein each of the fins is formed in a substantially rhombic shape in a front view.

5. The controller according to claim 1 or 2, wherein each of the fins is formed in a substantially polygonal shape including a triangular shape in a front view.

6. The controller according to claim 2, wherein the tapered surfaces of each of the fins are formed such that an opening area of an outlet portion of an air passage (19) formed between an adjacent pair of the fins is smaller than an opening area of an inlet portion of said air passage.

7. The controller according to claim 1, wherein tapered surfaces on both side surfaces of the fins are unified such that a demolding direction of the fins formed at the plurality of corners or on the outer peripheral surface is same.

8. The controller according to claim 7, wherein the demolding direction of the fins is a direction along a center axis of the vacuum pump device.

9. A vacuum pump device comprising the controller according to any one of claims 1 to 8.

## Patentansprüche

1. Steuereinrichtung (12) einschließlich eines Steuerkreises, der einen Betrieb eines Pumpenhauptkörpers (11) einer Vakuumpumpenvorrichtung (10,30) steuert, die Steuereinrichtung umfassend:
ein Steuereinrichtungsgehäuse (15), in dem der Steuerkreis untergebracht ist; und
**gekennzeichnet durch** eine Vielzahl von Wärmesenken (16), die einstückig mit dem Steuereinrichtungsgehäuse ausgebildet sind, und einschließlich einer Vielzahl von Rippen (17, 21, 33), die ausgebildet sind, um von einer äußeren Umfangsoberfläche des Steuereinrichtungsgehäuses nach außen vorzustehen,
wobei das Steuereinrichtungsgehäuse in einer Draufsicht in einer rechteckigen Form ausgebildet ist und eine Vielzahl von Ecken (12a) aufweist,
wobei die Vielzahl von Rippen der Vielzahl von Wärmesenken an jeder der Vielzahl von Ecken bereitgestellt sind, und
mindestens ein Indikator (18) in mindestens einem von Umfangsoberflächenabschnitten unter der Vielzahl von Ecken (12a) auf der Vorderseite des Steuereinrichtungsgehäuses (15) bereitgestellt ist.

2. Steuereinrichtung nach Anspruch 1, wobei
das Steuereinrichtungsgehäuse aus einem Gussstück hergestellt ist, und beide Seitenoberflächen von jeder der Rippen als konische Oberflächen (17a, 17b, 33a, 33b, 33c, 33d) ausgebildet sind, die zu einer Entformungsrichtung geneigt sind.

3. Steuereinrichtung nach Anspruch 1 oder 2, wobei jede der Rippen in einer Vorderansicht in einer im Wesentlichen trapezförmigen Form ausgebildet ist.

4. Steuereinrichtung nach Anspruch 1 oder 2, wobei jede der Rippen in einer Vorderansicht in einer im Wesentlichen rhombusförmigen Form ausgebildet ist.

5. Steuereinrichtung nach Anspruch 1 oder 2, wobei jede der Rippen in einer Vorderansicht in einer im Wesentlichen polygonalen Form, einschließlich einer dreieckigen Form, ausgebildet ist.

6. Steuereinrichtung nach Anspruch 2, wobei die konischen Oberflächen von jeder der Rippen derart ausgebildet sind, dass ein Öffnungsbereich eines Auslassabschnitts eines Luftkanals (19), der zwischen einem angrenzenden Paar der Rippen ausgebildet ist, kleiner als ein Öffnungsbereich eines Einlassabschnitts des Luftkanals ist.

7. Steuereinrichtung nach Anspruch 1, wobei die konischen Oberflächen auf beiden Seitenoberflächen der Rippen derart vereinigt sind, dass eine Entformungsrichtung der Rippen, die an der Vielzahl von Ecken oder auf der äußeren Umfangsoberfläche ausgebildet sind, gleich ist.

8. Steuereinrichtung nach Anspruch 7, wobei die Entformungsrichtung der Rippen eine Richtung entlang einer Mittelachse der Vakuumpumpenvorrichtung ist.

9. Vakuumpumpenvorrichtung, umfassend die Steuereinrichtung nach einem der Ansprüche 1 bis 8.

## Revendications

1. Dispositif de commande (12) comportant un circuit de commande qui commande un fonctionnement d'un corps principal de pompe (11) d'un dispositif de pompe à vide (10, 30), le dispositif de commande comprenant :
un boîtier de dispositif de commande (15) dans lequel est logé le circuit de commande ; et
**caractérisé par** une pluralité de dissipateurs thermiques (16) formés d'un seul tenant avec le boîtier de dispositif de commande et comportant une pluralité d'ailettes (17, 21, 33) formées de manière à faire saillie vers l'extérieur depuis une surface périphérique externe du boîtier de dispositif de commande,
dans lequel le boîtier de dispositif de commande est formé dans une forme rectangulaire dans une vue en plan et a une pluralité de coins (12a),
dans lequel la pluralité d'ailettes de la pluralité de dissipateurs thermiques sont pourvues sur chacun de la pluralité de coins, et
au moins un indicateur (18) est pourvu dans au moins l'une parmi des parties de surface périphériques parmi la pluralité de coins (12a) sur le côté avant du boîtier de dispositif de commande (15).

2. Dispositif de commande selon la revendication 1, dans lequel
le boîtier de dispositif de commande est réalisé en une coulée, et les deux surfaces latérales de chacune des ailettes sont formées en tant que surfaces coniques (17a, 17b, 33a, 33b, 33c, 33d) inclinées vers une direction de démoulage.

3. Dispositif de commande selon la revendication 1 ou 2, dans lequel chacune des ailettes est formée dans une forme sensiblement trapézoïdale dans une vue de face.

4. Dispositif de commande selon la revendication 1 ou 2, dans lequel chacune des ailettes est formée dans une forme sensiblement rhombique dans une vue de face.

5. Dispositif de commande selon la revendication 1 ou 2, dans lequel chacune des ailettes est formée dans une forme sensiblement polygonale comportant une forme triangulaire dans une vue de face.

6. Dispositif de commande selon la revendication 2, dans lequel les surfaces coniques de chacune des ailettes sont formées de telle sorte qu'une zone d'ouverture d'une partie de sortie d'un passage d'air (19) formé entre une paire adjacente des ailettes est plus petite qu'une surface d'ouverture d'une partie d'entrée dudit passage d'air.

7. Dispositif de commande selon la revendication 1, dans lequel des surfaces coniques sur les deux surfaces latérales des ailettes sont unifiées de sorte qu'une direction de démoulage des ailettes formées au niveau de la pluralité de coins ou sur la surface périphérique externe est la même.

8. Dispositif de commande selon la revendication 7, dans lequel la direction de démoulage des ailettes est une direction le long d'un axe central du dispositif de pompe à vide.

9. Dispositif de pompe à vide, comprenant le dispositif de commande selon l'une quelconque des revendications 1 à 8.
